# EUROPEAN PATENT APPLICATION

(11) **EP 4 123 728 A1**
(43) Date of publication of application: **25.01.2023**
(21) Application number: 20925202.2
(22) Date of filing: 18.03.2020
(51) Int. Cl.: H01L 31/0236, H01L 31/028, H01L 31/0368

(54) **PHOTODIODE AND METHOD FOR MANUFACTURING SAME**

(71) Applicant: LG Electronics, Inc., Yeongdeungpo-gu Seoul 07336 (KR)
(72) Inventor: SUNG, Jinwoo, Seoul 06772 (KR); RHO, Jonghyun, Seoul 06772 (KR)
(74) Representative: Katérle, Axel
(86) International application number: PCT/KR2020/003668
(87) International publication number: WO 2021/187634

(57) **Abstract**

The present disclosure relates to a photodiode and a method for manufacturing the same. The photodiode according to an embodiment of the present disclosure includes a semiconductor substrate; an insulating layer formed on the semiconductor substrate; an electrode formed on the insulating layer; and a graphene formed on the semiconductor substrate, the insulating layer, and the electrode, wherein the insulating layer includes an ion gel. In addition, various embodiments are possible.

## Description

### [Technical Field]

The present disclosure relates to a photodiode and a method for manufacturing the same, and more particularly, to a graphene-based photodiode and a method for manufacturing the same.

### [Background Art]

A photodiode is a device that converts an optical signal into an electrical signal at high speed, and is widely used as an essential component in various fields such as information processing field, communication field, and electronic industry field.

On the other hand, graphene is a carbon nanomaterial having a two-dimensional hexagonal carbon structure. Due to its high transmittance, high strength, and high electron mobility, research on graphene is being conducted worldwide in various fields such as displays and secondary batteries. In particular, research on graphene-based photodiodes using the physical properties of graphene is being actively conducted.

Since pure graphene-based photodiode has a relatively low photo-responsiveness due to low light absorption, in contrast to a fast response time due to high carrier mobility, research to improve the photo-responsiveness is being actively conducted. In particular, experiments and research are being conducted on heterojunction for photodetection, e.g., a heterojunction such as a Schottky junction between graphene and semiconductor, which is one of the simplest hybrid structures.

Recently, there is a research result that quantum efficiency is increased compared to a related art by forming an insulating layer and a gate electrode on graphene, and by lowering a driving voltage of a device by changing a work function of graphene through a gate voltage applied to the gate electrode, or by disposing graphene over silicon oxide SiO2 on a silicon Si substrate such that a graphene-Si heterojunction and a graphene/SiO2/Si field effect structure are formed. However, despite conventional experiments and studies on these graphene-based photodiodes, there is a continuing need for the development of graphene-based photodiode having higher photo-responsiveness, detectability and response speed, and a lower power consumption.

### [Disclosure]

### [Technical Problem]

The technical problem to be solved by the present disclosure will be described as follows.

First, the present disclosure provides a graphene-based photodiode including an insulating layer made of a component that improves photo-responsiveness, and a method for manufacturing the same.

Second, the present disclosure provides a photodiode capable of more stably forming a graphene on a semiconductor and an insulator, and a method for manufacturing the same.

The problems of the present disclosure are not limited to the problems mentioned above, and other problems not mentioned will be clearly understood by those skilled in the art from the following description.

### [Technical Solution]

According to an aspect of the present disclosure, there is provided a photodiode including: a semiconductor substrate; an insulating layer formed on the semiconductor substrate; an electrode formed on the insulating layer; and a graphene formed on the semiconductor substrate, the insulating layer, and the electrode, wherein the insulating layer includes an ion gel.

The graphene is formed to extend on the semiconductor substrate, the insulating layer, and the electrode.

The insulating layer is formed to cover a portion of the semiconductor substrate, the electrode is formed to cover a portion of the insulating layer, and the graphene is located to cover a portion of the electrode, an exposed portion of the insulating layer that is not covered by the electrode, and an exposed portion of the semiconductor substrate that is not covered by the insulating layer.

A thickness of a first area of the semiconductor substrate covered by the insulating layer is smaller than a thickness of a second area of the semiconductor substrate not covered by the insulating layer.

The thickness of the second area is the same as a sum of the thickness of the first area and a thickness of the insulating layer.

The ion gel of the insulating layer is formed to be spaced apart from each other on the semiconductor substrate, a plurality of the electrodes are respectively formed on the ion gel formed to be spaced apart from each other, and the graphene is formed to continuously extend on the semiconductor substrate, the ion gel formed to be spaced apart from each other, and the electrode that is formed on the ion gel formed to be spaced apart from each other.

The ion gel includes a block copolymer comprised of at least one selected from a group comprised of Polyethylene oxide (PEO), Polystyrene (PS), Polycaprolactone (PCL), Polyacrylonitrile (PAN), Polymethyl methacrylate (PMMA), Polyimide, and Polyvinylidene fluoride (PVDF) Polyvinylchloride (PVC).

The ion gel includes at least one selected from a group comprised of 1-ethyl-3-methylimidazolium bis (trifluoromethylsulfonyl)imide([EMIM][TFSI]), 1-butyl-3-methylimidazolium hexafluorophosphate([BMIM][PF6]), and 1-ethyl-3-methylimidazolium n-octylsulfate([EMIM][OctOSO3]).

According to another aspect of the present disclosure, there is provided a method of manufacturing a photodiode, including: forming an insulating layer on a semiconductor substrate; forming an electrode on the insulating layer; and forming a graphene on the semiconductor substrate, the insulating layer, and the electrode, wherein the insulating layer includes an ion gel.

In the forming of the insulating layer, the insulating layer is formed to cover a portion of the semiconductor substrate, in the forming of the electrode, the electrode is formed to cover a portion of the insulating layer, and in the forming of the graphene, the graphene may be transcribed to cover a portion of the electrode, an exposed portion of the insulating layer that is not covered by the electrode, and an exposed portion of the semiconductor substrate that is not covered by the insulating layer.

The forming an insulating layer includes: etching a first area of the semiconductor substrate; and forming the insulating layer on the first area,

In the forming of the insulating layer, the insulating layer is formed to have a thickness equal to a difference between the thickness of the second area not covered by the insulating layer of the semiconductor substrate and the thickness of the first area.

In the forming of the insulating layer, the ion gel of the insulating layer is formed to be spaced apart from each other on the semiconductor substrate, in the forming of the electrode, a plurality of the electrodes are respectively formed on the ion gel, in the forming of the graphene, the graphene is formed to extend on the semiconductor substrate, the ion gel, and the electrode formed on the ion gel.

The details of other embodiments are included in the detailed description and drawings.

### [Advantageous Effects]

According to various embodiments of the present disclosure, the photo-responsiveness and detectability of the photodiode can be improved by containing an ion gel having a large capacitance in the insulating layer.

In addition, according to various embodiments of the present disclosure, an insulating layer containing ion gel is formed along a trench structure of the semiconductor substrate to reduce a height difference between the insulating layer on which graphene is formed and the semiconductor substrate, thereby forming a graphene stably without breaking, and further improving the photo-responsiveness and detectability.

The effects of the present disclosure are not limited to the above-mentioned effects, and other effects not mentioned will be clearly understood by those skilled in the art from the description of the claims.

### [Description of Drawings]

FIG. 1 is a cross-sectional view of a photodiode according to an embodiment of the present disclosure.
FIGS. 2A to 2D are diagrams for explaining a method of manufacturing a photodiode of FIG. 1.
FIGS. 3 to 4B are diagrams for explaining an operation principle of the photodiode of FIG. 1.
FIGS. 5A and 5B are graphs showing a current density-voltage (J-V) curve of a photodiode.
FIG. 6 is a cross-sectional view of a photodiode according to another embodiment of the present disclosure.
FIGS. 7A to 7E are diagrams for explaining a method of manufacturing the photodiode of FIG. 6.

### [Mode for Invention]

Advantages and features of the present disclosure and methods of achieving them will become apparent with reference to the embodiments described below in detail in conjunction with the accompanying drawings. However, the present disclosure is not limited to the embodiments disclosed below, but may be implemented in various different forms, and these embodiments are provided only to allow the disclosure of the present disclosure to be complete, and to completely inform those of ordinary skill in the art to which the present disclosure belongs, the scope of the invention, and the present disclosure is only defined by the scope of the claims. Like reference numerals refer to like elements throughout.

The terms spatially relative, "below", "beneath", "lower", "above" and "upper" and the like can be used to easily describe the correlation of elements with other elements. Spatially relative terms should be understood in terms of the directions shown in the drawings, including the different directions of components at the time of use or operation. For example, when inverting an element shown in the drawings, an element described as "below" or "beneath" of another element may be placed "above" of another element. Thus, the exemplary term "below" may include both downward and upward directions. The elements may also be oriented in a different direction, so that spatially relative terms can be interpreted according to orientation.

The terminology used herein is for the purpose of illustrating embodiments and is not intended to restrict the invention. In this specification, singular forms include plural forms unless the context clearly dictates otherwise. It is noted that the terms "comprises" and/or "comprising" used in the specification mean that mentioned elements, steps, and/or operations do not exclude the presence or addition of one or more of other elements, steps, and/or operations.

Unless defined otherwise, all terms (including technical and scientific terms) used herein may be used in a sense commonly understood by a person having ordinary skill in the art to which the claimed invention pertains. In addition, commonly used predefined terms are not ideally or excessively interpreted unless explicitly defined otherwise.

In the drawings, the thicknesses and sizes of respective elements are exaggerated, omitted, or schematically shown for convenience and clarity of explanation. In addition, the size and area of each element do not entirely reflect actual size or area.

In general, suffixes such as "module" and "unit" may be used to refer to elements or components. Use of such suffixes herein is merely intended to facilitate description of the specification, and the suffixes do not have any special meaning or function.

In addition, in this specification, it will be understood that although the terms first, second, etc. may be used herein to describe various elements, these elements should not be limited by these terms. These terms are only used to distinguish one element from another.

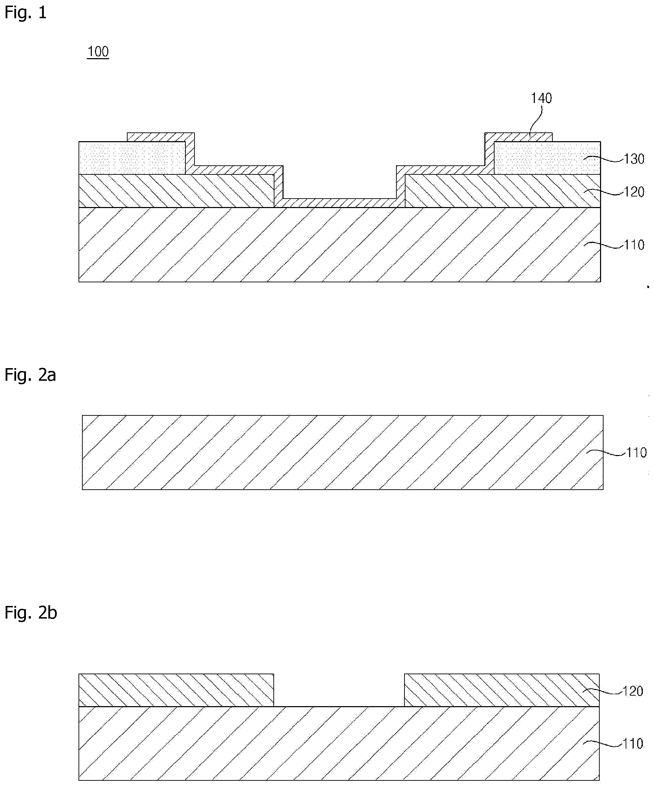

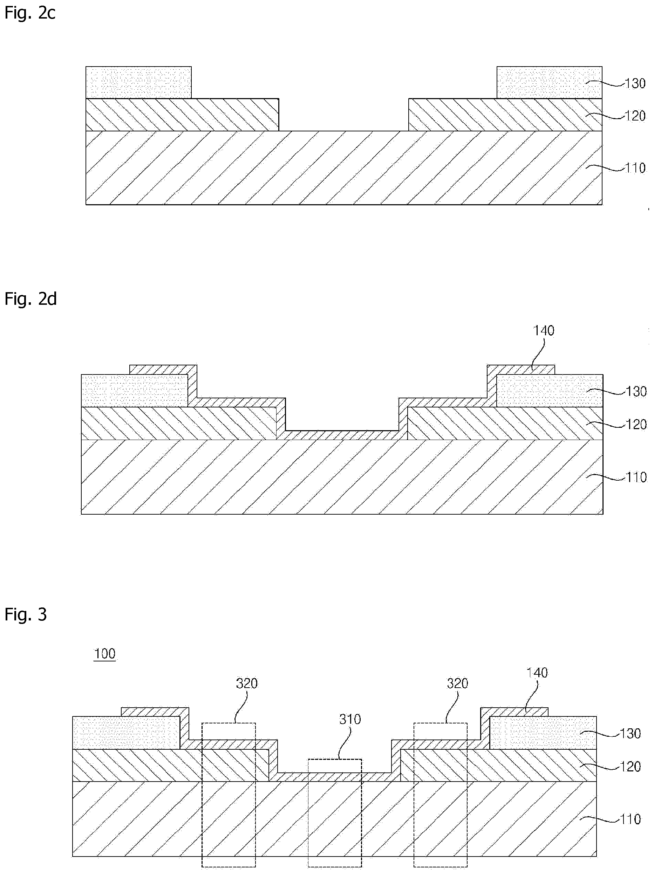

FIG. 1 is a cross-sectional view of a photodiode according to an embodiment of the present disclosure, and FIGS. 2A to 2D are diagrams for explaining a method of manufacturing a photodiode of FIG. 1.

Referring to FIGS. 1 to 2D, a photodiode 100 may include a semiconductor substrate 110, an insulating layer 120, an electrode 130, and a graphene 140.

The semiconductor substrate 110 may include a semiconductor having various magnitudes of energy band gap. For example, a semiconductor constituting the semiconductor substrate 110 may include Si, aSi, Ge, GaAs, GaN, InGaAs, AlGaAs, Metal Oxides, or the like.

The semiconductor substrate 110 may be formed of an n-type semiconductor or a p-type semiconductor. The semiconductor substrate 110 may be made of a commonly used semiconductor, but is not limited thereto, and may be made of various materials.

The present disclosure is described based on an embodiment in which the semiconductor substrate 110 is formed of an n-type semiconductor, but not limited thereto. For example, when the semiconductor substrate 110 is formed of a p-type semiconductor, it can be understood that the types of voltage bias and moving charges applied to the semiconductor substrate 110 are changed compared to a case where the semiconductor substrate 110 is formed of an n-type semiconductor.

The insulating layer 120 may be formed on the semiconductor substrate 100. In this case, the insulating layer 120 may be formed to be spaced apart from each other on the semiconductor substrate 100 so as to cover a portion of the semiconductor substrate 100. The insulating layer 120 may be formed on the semiconductor substrate 100 to be spaced apart from each other.

The insulating layer 120 may be formed of an ion gel. The ion gel may be formed of a mixture of a block copolymer and an ionic liquid. The block copolymer may be formed of at least one selected from a group consisting of Polyethylene oxide (PEO), Polystyrene (PS), Polycaprolactone (PCL), Polyacrylonitrile (PAN), Polymethyl methacrylate (PMMA), Polyimide, and Polyvinylidene fluoride (PVDF) Polyvinylchloride (PVC). The ionic liquid may be formed of at least one selected from a group consisting of 1-ethyl-3-methylimidazolium bis(trifluoromethylsulfonyl)imide ([EMIM][TFSI]), 1-butyl-3-methylimidazolium hexafluorophosphate([BMIM][PF6]), and 1-ethyl-3-methylimidazolium n-octylsulfate ([EMIM][OctOSO3]).

For example, after being coated on the semiconductor substrate 100, the ion gel may be hardened by exposure to ultraviolet (UV) light. Meanwhile, the process method of the insulating layer 120 is not limited thereto, and various methods may be used.

The electrode 130 may be formed on the insulating layer 120. In this case, a plurality of the electrodes 130 may be formed to be disposed on the insulating layer 120 spaced apart from each other.

The electrode 130 may include a conductive material such as chromium Cr, gold Au, platinum Pt, aluminum Al, aluminum alloy (Al alloy), copper Cu, nickel Ni, tungsten W, molybdenum Mo, titanium Ti, or tantalum Ta, and may be formed in a multilayer structure in which two or more conductive materials are stacked in some embodiment. In addition, the electrode 130 may include a transparent conductive material such as indium tin oxide ITO, indium zinc oxide IZO, or indium tin zinc oxide ITZO.

The electrode 130 may be formed using at least one method among a vacuum deposition, a chemical vapor deposition, a physical vapor deposition, an atomic layer deposition, a metal organic chemical vapor deposition, a plasma-enhanced chemical vapor deposition, a molecular beam epitaxy, a hydride vapor phase epitaxy, a sputtering, a spin coating, a dip coating, and a zone casting.

The graphene 140 may be formed on the semiconductor substrate 110, the insulating layer 120, and the electrode 130. For example, it may be transcribed onto the semiconductor substrate 110, the insulating layer 120, and the electrode 130.

The graphene 140 may be formed to extend without breaking on the semiconductor substrate 110, the insulating layer 120, and the electrode 130. For example, the graphene 140 may be formed to extend without breaking so as to cover all of a portion of the electrode 130, an exposed portion of the insulating layer 120 that is not covered by the electrode 130, and a portion of the semiconductor substrate 110 that is not covered by the insulating layer 120.

The graphene 140 may be a single-layered graphene, or two or more multilayered graphenes.

The graphene 140 may be manufactured according to a method such mechanical exfoliation that is mechanically exfoliated from graphite, chemical vapor deposition, epitaxial growth, or chemical exfoliation using a oxidation/reduction reaction of graphite.

The graphene 140 may be n-type graphene or p-type graphene. Here, n-type graphene may refer to graphene in which electrons transport charges, and p-type graphene may refer to graphene in which holes transport charges.

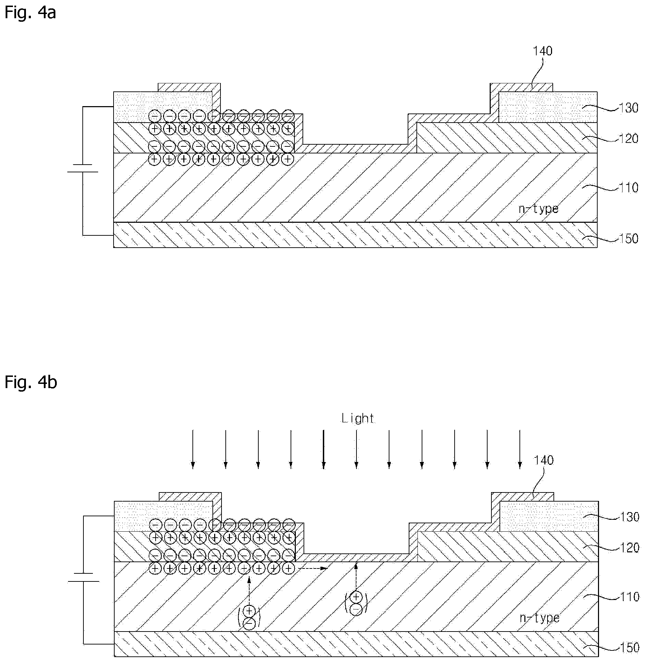

Meanwhile, an additional electrode (e.g. 150 of FIG. 4) may be in contact with the semiconductor substrate 100. In this case, the additional electrode may form an ohmic contact with the semiconductor substrate 100. Here, the ohmic contact may mean bonding of a metal and a semiconductor whose voltage-current characteristic follow Ohm's law in order to prevent a potential barrier for carriers from being formed, as a potential barrier may be formed at a contact surface, when a metal comes into contact with a semiconductor having a low impurity concentration.

The additional electrodes may be made of any one of gold Au, silver Ag, tin Sn, tungsten W, chromium Cr, molybdenum Mo, aluminum Al, titanium Ti, platinum Pt, gallium Ga, indium In, and rhenium Re, or a combination thereof, but is not limited thereto, and may be made of various materials.

Referring to FIG. 3, a Schottky junction structure may be formed in an area 310 where the semiconductor substrate 110 and the graphene 140 contact each other. In addition, a metal-oxide semiconductor MOS structure may be formed in an area 320 where the semiconductor substrate 110, the insulating layer 120, and the graphene 140 sequentially contact each other.

Meanwhile, referring to FIG. 4A, a positive(+) voltage is applied the additional electrode 150 in contact with the semiconductor substrate 110 made of the n-type semiconductor, a reverse bias voltage, which is a negative(-) voltage applied to the electrode 130 in contact with the graphene 140, may be applied to the photodiode 100. At this time, as holes are accumulated in the n-type semiconductor, an inversion layer may be formed on an interface of the semiconductor substrate 110, and as the inversion layer is formed, it is possible to prevent the disappearance of holes of photo-generated electron-hole pairs due to the recombination center.

Meanwhile, the ion gel may be configured such that the capacitance is significantly higher than that of an existing inorganic material such as silicon oxide SiOx. For example, the capacitance of silicon dioxide (SiO2) is 0.0328uF/cm2. On the other hand, when ion gel is manufactured by mixing a block copolymer formed of Polyethylene oxide PEO and Polystyrene PS, 1-Ethyl-3-methylimidazoliumbis(trifluoromethylsulfonyl)imide([EMIM][TFSI]),1-butyl-3-methylimidazolium hexafluorophosphate([BMIM][PF6]]), and 1-Ethyl-3-methylimidazolium n-octylsulfate([EMIM][OctOSO3]), the capacitance is 40uF/cm2, which is significantly higher than that of dioxide SiO2. In addition, due to the high capacitance of the ion gel, when the insulating layer 120 is formed of the ion gel, the permittivity of the insulating layer 120 may also be significantly higher than that of an existing inorganic material such as silicon oxide SiOx.

Thus, when the photodiode 100 includes the insulating layer 120 made of ion gel, the properties of the ion gel as an insulator are maintained, within a voltage range where ions do not undergo chemical reaction, and furthermore, due to a high permittivity of ion gel and a role of gate, an inversion layer may be formed in the interface of the semiconductor substrate 100 even at a lower voltage than a case of using an existing inorganic material.

In addition, when the insulating layer is formed using an existing inorganic material, it is necessary to maximally reduce the thickness of the insulating layer in order to increase the permittivity, but there is a technical limit in reducing the thickness of the insulating layer. On the other hand, when the insulating layer is formed of ion gel, the actual thickness of the insulating layer is the thickness of the electric double layer. Thus, since the thickness of the insulating layer can be determined as needed, an insulating layer having a high permittivity can be formed only by a simple process.

Referring to FIG. 4B, when light is irradiated while a reverse bias voltage is applied to the photodiode 100, photo-generated electron-hole pairs may be generated in the n-type semiconductor of the semiconductor substrate 100.

In the area 310 in which a Schottky junction structure is formed, the holes of photo-generated electron-hole pairs may be moved to the graphene 140, and may be extracted through graphene 140.

In the area 320 where the MOS structure is formed, the holes of photo-generated electron-hole pairs may be moved to the interface of the semiconductor substrate 100 and accumulated according to the bending of the energy band.

Meanwhile, since bending of the energy band exists between the Schottky junction structure and the MOS structure, the holes accumulated along the interface of the semiconductor substrate 100 may be moved to the graphene 140 of the area 310 in which the Schottky junction structure is formed. At this time, due to the inversion layer formed in the interface of the semiconductor substrate 110, the holes may be smoothly moved to the graphene 140 in the area 310 where the Schottky junction structure is formed.

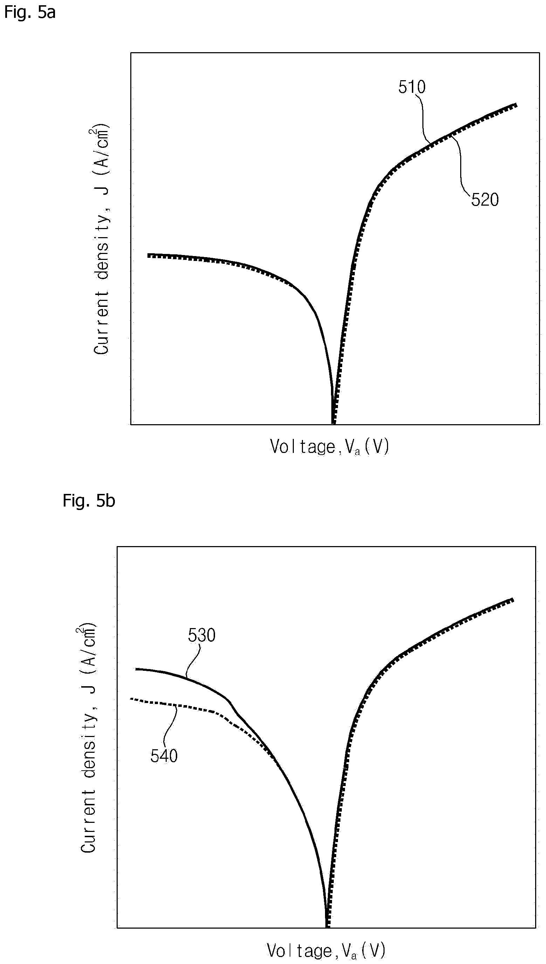

FIG. 5A is a graph showing a current density-voltage (J-V) curve of the photodiode when no light is irradiated, and FIG. 5B is graph showing a current density-voltage (J-V) curve of the photodiode when light is irradiated.

Referring to FIG. 5A, in the case where light is not irradiated to the photodiode 100, when the current density-voltage (J-V) curve 510 in a case where the insulating layer 120 is formed of ion gel is compared with the current density-voltage (J-V) curve 520 in a case where the insulating layer 120 is formed of an existing inorganic material, it can be seen that there is little difference between two graphs.

Meanwhile, referring to FIG. 5B, in the case where light is irradiated to the photodiode 100, when the current density-voltage (J-V) curve 510 in a case where the insulating layer 120 is formed of ion gel is compared with the current density-voltage (J-V) curve 520 in a case where the insulating layer 120 is formed of an existing inorganic material, it can be seen that more photocurrent flows in the photodiode 100 including the insulating layer 120 formed of ion gel, compared to a case where the insulating layer 120 is formed of an existing inorganic material. Through this, when the insulating layer 120 is formed of ion gel, it can be seen that the photo-responsiveness and detectability are further improved compared to a conventional photodiode.

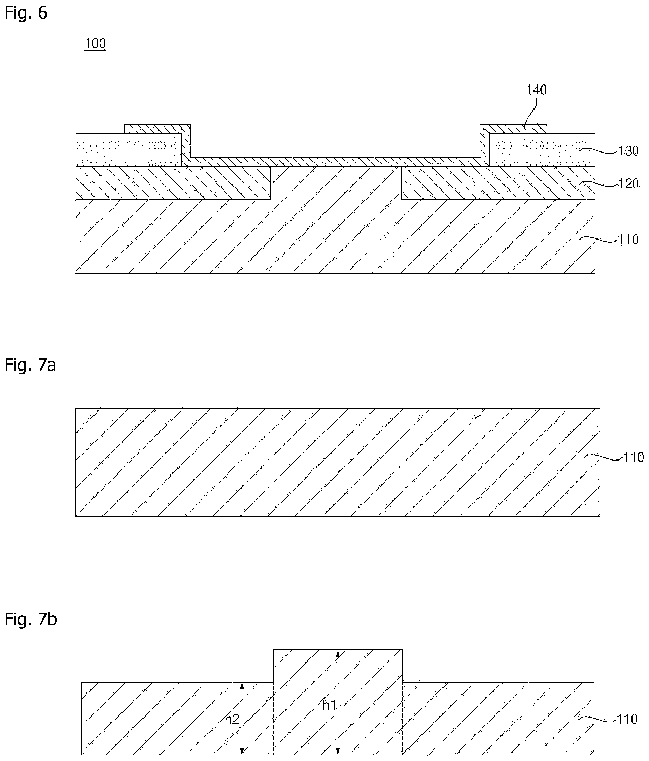

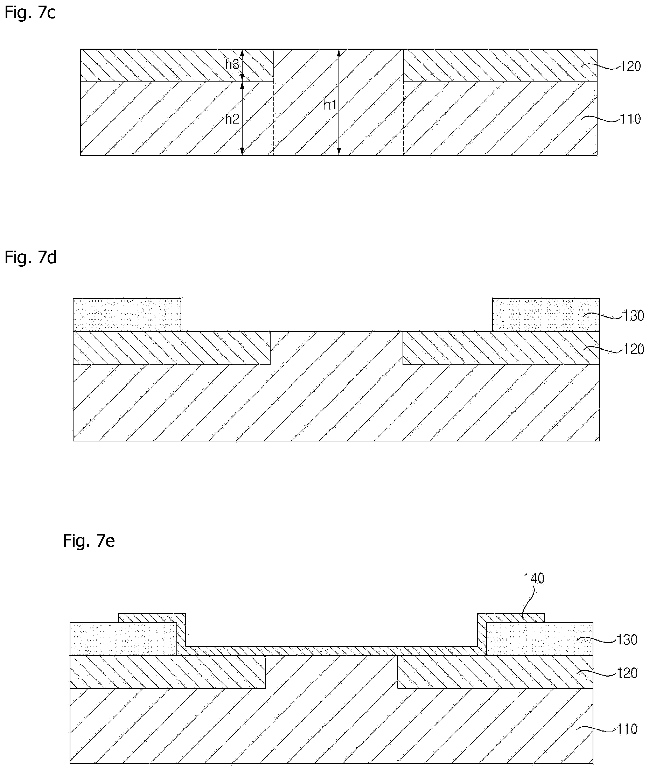

FIG. 6 is a cross-sectional view of a photodiode according to another embodiment of the present disclosure, and FIGS. 7A to 7E are diagrams for explaining a method of manufacturing the photodiode of FIG. 6. A detailed description of the content overlapping with the content described in FIGS. 1 to 2D will be omitted.

Referring to FIGS. 6 to 7E, the semiconductor substrate 110 may include a trench structure having an inverted T shape. For example, one area of the semiconductor substrate 110 may be etched to a certain depth so that a thickness h2 of one area of the semiconductor substrate 110 is smaller than a thickness h1 of the other area.

The insulating layer 120 may be formed on an area etched to a certain depth, in the semiconductor substrate 100. In this case, the insulating layer 120 may be formed with a thickness h3 equal to a difference between the thickness h1 of the unetched area of the semiconductor substrate 100 and the thickness h2 of the etched area.

The electrode 130 may be formed on the insulating layer 120. In this case, a plurality of electrodes 130 may be formed to be disposed on the insulating layer 120 spaced apart from each other.

The graphene 140 may be formed on the semiconductor substrate 110, the insulating layer 120, and the electrode 130. For example, it may be transcribed onto the semiconductor substrate 110, the insulating layer 120, and the electrode 130. At this time, since the height between the interface of the insulating layer 120 on which the graphene 140 is formed and the interface of the semiconductor substrate 110 on which the graphene 140 is formed is the same, the graphene 140 may be stably formed on the semiconductor substrate 110 and the insulating layer 120 without being broken.

Meanwhile, when the semiconductor substrate 110 includes a trench structure, and when the insulating layer 120 is formed according to a trench structure so that the area of the semiconductor substrate 110 in contact with the insulating layer 120 formed of ion gel increases, photo-responsiveness and detectability may be further improved due to a reason that the inversion layer is formed to be wider.

As described above, according to various embodiments of the present disclosure, the insulating layer 120 is formed of an ion gel having a large capacitance, thereby improving the photo-responsiveness and detection ability of the photodiode 100.

In addition, the height difference between the insulating layer 120 on which the graphene 140 is formed and the semiconductor substrate 110 can be reduced, by forming the insulating layer 120 including the ion gel according to the trench structure of the semiconductor substrate 110, thereby forming the graphene 110 without being broken, and improving the photo-responsiveness and detection ability.

Since the accompanying drawings are merely for easily understanding embodiments disclosed herein, it should be understood that the technical spirit disclosed herein is not limited by the accompanying drawings, and all changes, equivalents or substitutions are included in the spirit and technical scope of the present disclosure.

Likewise, although operations are shown in a specific order in the drawings, it should not be understood that the operations are performed in the specific order shown in the drawings or in a sequential order so as to obtain desirable results, or all operations shown in the drawings are performed. In certain cases, multitasking and parallel processing may be advantageous.

Although the present disclosure has been described with reference to specific embodiments shown in the drawings, it is apparent to those skilled in the art that the present description is not limited to those exemplary embodiments and is embodied in many forms without departing from the scope of the present disclosure, which is described in the following claims. These modifications should not be individually understood from the technical spirit or scope of the present disclosure.

## Claims

1. A photodiode comprising:
a semiconductor substrate;
an insulating layer formed on the semiconductor substrate;
an electrode formed on the insulating layer; and
a graphene formed on the semiconductor substrate, the insulating layer, and the electrode,
wherein the insulating layer comprises an ion gel.

2. The photodiode of claim 1, wherein the graphene is formed to extend on the semiconductor substrate, the insulating layer, and the electrode.

3. The photodiode of claim 2, wherein the insulating layer is formed to cover a portion of the semiconductor substrate,
the electrode is formed to cover a portion of the insulating layer, and
the graphene is located to cover a portion of the electrode, an exposed portion of the insulating layer that is not covered by the electrode, and an exposed portion of the semiconductor substrate that is not covered by the insulating layer.

4. The photodiode of claim 3, wherein a thickness of a first area of the semiconductor substrate covered by the insulating layer is smaller than a thickness of a second area of the semiconductor substrate not covered by the insulating layer.

5. The photodiode of claim 4, wherein the thickness of the second area is the same as a sum of the thickness of the first area and a thickness of the insulating layer.

6. The photodiode of claim 5, wherein the ion gel of the insulating layer is formed to be spaced apart from each other on the semiconductor substrate,
a plurality of the electrodes are respectively formed on the ion gel formed to be spaced apart from each other, and
the graphene is formed to extend on the semiconductor substrate, the ion gel formed to be spaced apart from each other, and the electrode that is formed on the ion gel formed to be spaced apart from each other.

7. The photodiode of claim 1, wherein the ion gel comprises a block copolymer comprised of at least one selected from a group comprised of Polyethylene oxide (PEO), Polystyrene (PS), Polycaprolactone (PCL), Polyacrylonitrile (PAN), Polymethyl methacrylate (PMMA), Polyimide, and Polyvinylidene fluoride (PVDF) Polyvinylchloride (PVC).

8. The photodiode of claim 7, wherein the ion gel comprises at least one selected from a group comprised of 1-ethyl-3-methylimidazolium bis (trifluoromethylsulfonyl)imide([EMIM][TFSI]), 1-butyl-3-methylimidazolium hexafluorophosphate([BMIM][PF6]), and 1-ethyl-3-methylimidazolium n-octylsulfate([EMIM][OctOSO3]).

9. A photodetector comprising the photodiode of any one of claims 1 to 8.

10. A method of manufacturing a photodiode, the method comprising:
forming an insulating layer on a semiconductor substrate;
forming an electrode on the insulating layer; and
forming a graphene on the semiconductor substrate, the insulating layer, and the electrode,
wherein the insulating layer comprises an ion gel.

11. The method of claim 10, wherein forming a graphene comprises forming the graphene to extend on the semiconductor substrate, the insulating layer, and the electrode.

12. The method of claim 11, wherein, in the forming of the insulating layer, the insulating layer is formed to cover a portion of the semiconductor substrate,
in the forming of the electrode, the electrode is formed to cover a portion of the insulating layer, and
in the forming of the graphene, the graphene may be transcribed to cover a portion of the electrode, an exposed portion of the insulating layer that is not covered by the electrode, and an exposed portion of the semiconductor substrate that is not covered by the insulating layer.

13. The method of claim 12, wherein forming an insulating layer comprises:
etching a first area of the semiconductor substrate; and
forming the insulating layer on the first area,
wherein a thickness of the first area is smaller than a thickness of a second area of the semiconductor substrate not covered by the insulating layer.

14. The method of claim 13, wherein in the forming of the insulating layer, the insulating layer is formed to have a thickness equal to a difference between the thickness of the second area and the thickness of the first area.

15. The method of claim 14, wherein in the forming of the insulating layer, the ion gel of the insulating layer is formed to be spaced apart from each other on the semiconductor substrate,
in the forming of the electrode, a plurality of the electrodes are respectively formed on the ion gel formed spaced apart from each other,
in the forming of the graphene, the graphene is formed to extend on the semiconductor substrate, the ion gel formed to be spaced apart from each other, and the electrode formed on the ion gel formed to be spaced apart from each other.

16. The method of claim 15, wherein the ion gel comprises a block copolymer comprised of at least one selected from a group comprised of Polyethylene oxide (PEO), Polystyrene (PS), Polycaprolactone (PCL), Polyacrylonitrile (PAN), Polymethyl methacrylate (PMMA), Polyimide, and Polyvinylidene fluoride (PVDF) Polyvinylchloride (PVC).

17. The method of claim 16, wherein the ion gel comprises at least one selected from a group comprised of 1-ethyl-3-methylimidazolium bis (trifluoromethylsulfonyl)imide([EMIM][TFSI]), 1-butyl-3-methylimidazolium hexafluorophosphate([BMIM][PF6]), and 1-ethyl-3-methylimidazolium n-octylsulfate([EMIM][OctOSO3]).
